# EUROPEAN PATENT APPLICATION

(11) **EP 3 076 439 A1**
(43) Date of publication of application: **05.10.2016**
(21) Application number: 15743505.8
(22) Date of filing: 23.01.2015
(51) Int. Cl.: H01L 31/048

(54) **ENCAPSULATION FILM FOR SOLAR CELL MODULE**

(30) Priority: 28.01.2014 CN 201410041585
(71) Applicant: Changzhou Andy New Materials Co., Ltd., Changzhou, Jiangsu 213017 (CN)
(72) Inventor: LIN, Jinxi, Changzhou Jiangsu 213017 (CN); DING, Huaixin, Changzhou Jiangsu 213017 (CN); LI, Zheng, Changzhou Jiangsu 213017 (CN)
(74) Representative: Sun, Yiming
(86) International application number: PCT/CN2015/071389
(87) International publication number: WO 2015/113477

(57) **Abstract**

The present invention provides an encapsulation adhesive film for solar cell modules, which is obtained by mixing a transparent spherical material with an average particle diameter of 0.1 µm to 50 µm during the process of manufacturing the encapsulation adhesive film. The weight of the transparent spherical material is 0.01% to 10% of the total weight of the encapsulation adhesive film. The transparent spherical material may include at least one of transparent polymer microspheres, transparent spherical glass beads, and transparent spherical ceramic beads. The transparent polymer microspheres may include at least one of PMMA microspheres, PC microspheres, PS microspheres, and PET microspheres. The disclosed encapsulation adhesive film incorporates transparent spherical materials, whose diffuse reflection characteristics may be utilized to increase the number of times of reflecting and refracting of light in the adhesive film, which further improves luminous flux of the solar cell module, thereby increasing power generation.

## Description

### FIELD OF THE DISCLOSURE

The present disclosure generally relates to the field of photovoltaic module technologies and, more particularly, relates to an encapsulation adhesive film for solar cell modules.

### BACKGROUND

With global development of economy and society, energy supply crisis becomes increasingly severe. Further, development and utilization of fossil energy have become one of the main causes of environmental pollution and deterioration of the natural environment for human survival. Therefore, development and utilization of new energy sources has become a major problem that needs to be addressed for the development of human society.

In a variety of new energy sources, photovoltaic cells utilizing solar power to generate electricity are highly valued around the world for having many advantages, such as non-polluting, sustaining, large total volume, widely distributed, various usage forms, etc. In China, developing solar photovoltaic industry has become an important means to secure energy supply and promote economic restructuring. "The '12th Five-Year' Plan of Solar Photovoltaic Industry" clearly states that: the photovoltaic power generation capacity in China is projected to increase from the current 0.8GW to 10GW in year 2015 and to 50GW in year 2020, respectively. "Decision of the State Council on accelerating cultivation and development of strategic emerging industries" has included the photovoltaic industry as an important direction for the future development of strategic emerging industries in China.

With further development of photovoltaic industry, increasing power generation per unit area (also called generated power output) has become the main theme of improving the development of photovoltaic technology.

The main components of a photovoltaic module (also called a solar cell module) may include a tempered glass, a solar cell layer, and a backplane, with encapsulation adhesive films in between for bonding these main components. The adhesive film bonding the tempered glass and the solar cell layer is commonly referred as an upper-layer adhesive film, and the adhesive film bonding the solar cell layer and the backplane is commonly referred as a lower-layer adhesive film.

Existing methods for improving power generation of solar cell modules mainly include: increasing transmittance of the tempered glass, increasing conversion efficiency of the solar cell layer, and increasing reflectivity of the backplane.

In recent years, some literatures have reported that improvements of the lower-layer adhesive film may increase the power generation.

However, no reports or literatures have been found to increase the power generation by improving the upper-layer adhesive film.

### BRIEF SUMMARY OF THE DISCLOSURE

The present disclosure is directed to solve the problem set forth above and provides an encapsulation adhesive film for a solar cell module, when the disclosed encapsulation adhesive film is used as upper-layer adhesive film, the power generation/output of the solar cell module can be increased.

The technical solution to implement the purpose of the present disclosure is: providing an encapsulation adhesive film for a solar cell module, which is obtained by mixing a transparent spherical material with an average particle diameter of 0.1 µm to 50 µm during the adhesive film preparation process.

The transparent spherical material may include at least one of transparent spherical polymer beads (also called transparent polymer microspheres), transparent spherical glass beads (also called transparent glass microspheres), and transparent spherical ceramic beads (also called transparent ceramic microspheres), and preferably the transparent spherical polymer beads or the transparent spherical glass beads.

The transparent polymer microspheres may include at least one of PMMA (polymethyl methacrylate) microspheres, PC (polycarbonate) microspheres, PS (polystyrene) microspheres, and PET (polyethylene terephthalate) microspheres.

The weight of the transparent spherical material is 0.01% to 10% of the total weight of the encapsulation adhesive film, and is preferably 0.1 % to 1% of the total weight.

The average particle diameter of the transparent spherical material is preferably 1 µm to 5 µm.

Currently, a common process of preparing the encapsulation adhesive film may include: first mixing bulk materials and additives uniformly, then adding the mixture to an extruder for melting and extruding the mixture, followed by a cooling and molding process, a drawing and rolling process to form a final adhesive film product.

The bulk materials may be POE (ethylene-octene copolymer), EVA (ethylene-vinyl acetate copolymer), PVB (polyvinyl butyral), TPU (thermoplastic polyurethane), epoxy, silicones, etc. One type of the bulk materials may be adopted, or two or more types of the bulk materials may be adopted for preparing the encapsulation adhesive film.

The additives may generally include crosslinking agent, auxiliary crosslinking agent, tackifier, ultraviolet absorber, antioxidant, coupling agent, etc.

The transparent spherical materials disclosed in the present invention may be mixed into the bulk materials and auxiliary materials during the mixing process when the bulk materials and the additives are uniformly mixed.

### DETAILED DESCRIPTION

### (Example 1)

In one embodiment, the disclosed encapsulation adhesive film for solar cell modules may use POE (ethylene-octene copolymer) as a bulk material. The encapsulation firm may include the following components by weight.

The components may include: 100 g of POE, 0.7 g of tert-Butylperoxy 2-ethylhexyl carbonate, 0.5 g of trimethylolpropane trimethacrylate, 0.5 g of 3-methacryloyloxytrimethoxysilane, 0.3 g of 2-hydroxy-4-n-octyloxybenzophenone (UV-531), and 1 g of transparent spherical glass beads with an average particle diameter of about 5µm.

After uniformly mixing these components, the encapsulation adhesive film may be formed using the above described common process of preparing the encapsulation adhesive film.

### (Example 2 to Example 5)

The components of the disclosed encapsulation adhesive films in these Examples are substantially the same as the ones in Example 1, except type, particle diameter, and amount of the transparent spherical materials. Table 1 discloses detailed descriptions of the different transparent spherical materials used in Examples 2-5.

### (Comparative Example 1)

The components of the encapsulation adhesive film in Comparative Example 1 are substantially the same as the ones in Example 1, except that the transparent spherical material is not mixed in the encapsulation adhesive film in Comparative Example 1. Table 1 discloses detailed results of Comparative Example 1.

### (Application Example 1)

Six solar cell modules were prepared using a solar cell module preparation method based on the same sets of a tempered glass, a solar cell layer, and a backplane. Encapsulation adhesive films prepared from Examples 1 through 5, and Comparative Example 1 were respectively used as an upper-layer adhesive film for bonding the tempered glass and the solar cell layer, and the encapsulation adhesive film prepared from Comparative Example 1 was also used as a lower-layer adhesive film for bonding the solar cell layer and the backplane. The generated power output of each of the six solar cell modules was measured, and results are listed in Table 1.

**Table 1**

| | Example 1 | Example 2 | Example 3 | Example 4 | Example 5 | Comparative Example 1 |
|---|---|---|---|---|---|---|
| Transparent spherical material | 1g of glass beads with 5µm diameter | 0.5g of glass beads with 5µm diameter | 0.1g of glass beads with 5µm diameter | 1g of PMMA microspheres with 5µm diameter | 1g of ceramic beads with 5µm diameter | -- |
| Open-circuit voltage (V) | 5.5537 | 5.5691 | 5.642008 | 5.5662 | 8.299372 | 5.635516 |
| Short circuit current (A) | 8.1946 | 8.2016 | 8.303635 | 8.192 | 8.302283 | 7.855639 |
| Maximum Power (W) | 34.4885 | 34.5569 | 34.76768 | 34.4585 | 34.7637 | 33.12015 |
| Power Factor | 0.7578 | 0.7568 | 0.745225 | 0.7557 | 0.742306 | 0.74813 |

As shown in Table 1, encapsulation adhesive films incorporating the disclosed transparent spherical material have increased the power output of the solar cell module in a certain amount.

### (Example 6)

In one embodiment, the disclosed encapsulation adhesive film for solar cell modules may use EVA (ethylene-vinyl acetate copolymer) as a bulk material. The encapsulation firm may include the following components by weight.

The components may include: 100 g of EVA, 0.8 g of tert-Amylperoxy 2-ethylhexyl carbonate, 0.1 g of antioxidant 168, 0.5 g of UV-622 (Poly(4-hydroxy-2,2,6,6-tetramethyl-1-piperidine ethanol-alt-1,4-butanedioic acid)), and 1 g of PMMA microspheres with an average particle diameter of about 5 µm.

After uniformly mixing these components, the encapsulation adhesive film may be formed using the above described common process of preparing the encapsulation adhesive film.

### (Example 7 to Example 10)

The components of the disclosed encapsulation adhesive films in these Examples are substantially the same as the ones in Example 6, except material, particle diameter, and amount of the transparent microspheres. Table 2 discloses detailed descriptions and results of Examples 7-10.

### (Comparative Example 2)

The components of encapsulation adhesive film in Comparative Example 2 are substantially the same as the ones in Example 6, except that the transparent microspheres are not mixed in the encapsulation adhesive film in Comparative Example 2. Table 2 discloses detailed results of Comparative Example 2.

### (Application Example 2)

Six solar cell modules were prepared using a solar cell module preparation method based on the same sets of a tempered glass, a solar cell layer, and a backplane. Encapsulation adhesive films prepared from Examples 6 through 10, and Comparative Example 2 were respectively used as an upper-layer adhesive film for bonding the tempered glass and the solar cell layer, and the encapsulation adhesive film prepared from Comparative Example 2 was also used as a lower-layer adhesive film for bonding the solar cell layer and the backplane in each of the six solar cell modules. The generated power output of each of the six solar cell modules was measured, and results are listed in Table 2.

**Table 2**

| | Example 6 | Example 7 | Example 8 | Example 9 | Example 10 | Comparativ e Example 2 |
|---|---|---|---|---|---|---|
| Transparent spherical materials | 1g of PMMA microspheres with 5µm diameter | 1 g of PC microspheres with 5µm diameter | 1 g of PS microspheres with 5µm diameter | 1g of glass beads with 5µm diameter | 0.1g of PMMA microspheres with 5µm diameter | - |
| Open-circuit voltage (V) | 5.563117 | 5.56888 | 5.641238 | 5.568215 | 5.564935 | 5.631616 |
| Short circuit current (A) | 8.248803 | 8.202847 | 8.302283 | 8.202558 | 8.247557 | 7.8551 |
| Maximum Power (W) | 34.48221 | 34.56691 | 34.7381 | 34.56165 | 34.48772 | 33.08241 |
| Power Factor | 0.751426 | 0.756708 | 0.74171 | 0.75671 | 0.751414 | 0.747846 |

As shown in Table 2, encapsulation adhesive films incorporating the disclosed transparent spherical material have increased the power output of the solar cell module in a certain amount.

### (Example 11)

In one embodiment, the disclosed encapsulation adhesive film for solar cell modules may use PVB (polyvinyl butyral) as a bulk material. The encapsulation firm may include the following components by weight.

The components may include: 100 g of PVB, 5 g of triethylene glycol bis(2-ethylhexanoate), 5 g of EAA (ethylene-acrylic acid copolymer), 0.2 g of antioxidant 1076, 0.2 g of antioxidant 1010, 0.3 g of UV-770 (Bis(2,2,6,6-tetramethyl-4-piperidyl)sebacate), and 0.5 g of transparent spherical glass beads with an average particle diameter of about 20 µm.

After uniformly mixing these components, the encapsulation adhesive film may be formed using the above described common process of preparing the encapsulation adhesive film.

### (Example 12 to Example 15)

The components of the disclosed encapsulation adhesive films in these Examples are substantially the same as the ones in Example 11, except type, particle diameter, and amount of the transparent spherical beads. Table 3 discloses detailed descriptions and results of Examples 12-15.

### (Comparative Example 3)

The components of encapsulation adhesive film in Comparative Example 3 are substantially the same as the ones in Example 11, except that the transparent spherical materials are not mixed in the encapsulation adhesive film in Comparative Example 3. Table 3 discloses detailed results of Comparative Example 3.

### (Application Example 3)

Six solar cell modules were prepared using a solar cell module preparation method based on the same sets of a tempered glass, a solar cell layer, and a backplane. Encapsulation adhesive films prepared from Examples 11 through 15, and Comparative Example 3 were respectively used as an upper-layer adhesive film for bonding the tempered glass and the solar cell layer, and the encapsulation adhesive film prepared from Comparative Example 3 was also used as a lower-layer adhesive film for bonding the solar cell layer and the backplane. The generated power output of each of the six solar cell modules was measured, and results are listed in Table 3.

**Table 3**

| | Example 11 | Example 12 | Example 13 | Example 14 | Example 15 | Comparative Example 3 |
|---|---|---|---|---|---|---|
| Transparent spherical materials | 0.5g of glass beads with 20µm diameter | 5g of glass beads with 20µm diameter | 0.05g of PMMA microspheres with 20µm diameter | 0.5g of glass beads with 10µm diameter | 0.5g of glass beads with 50µm diameter | - |
| Open-circuit voltage (V) | 5.570275 | 5.630178 | 5.566446 | 5.635826 | 5.565386 | 5.634753 |
| Short circuit current (A) | 8.199447 | 34.37959 | 8.193657 | 8.150106 | 8.191306 | 7.85468 |
| Maximum Power (W) | 34.57211 | 34.37959 | 34.46361 | 34.32605 | 34.45411 | 33.12825 |
| Power Factor | 0.756946 | 0.749287 | 0.755623 | 0.747314 | 0.755775 | 0.748506 |

As shown in Table 3, encapsulation adhesive films incorporating the disclosed transparent spherical material have increased the power output of the solar cell module in a certain amount.

### (Example 16)

In one embodiment, the disclosed encapsulation adhesive film for solar cell modules may use both POE and EVA as bulk materials. The encapsulation firm may include the following components by weight.

The components may include: 80 g of EVA, 10 g of POE, 10 g of PE (polyethylene), 0.6 g of tert-Butylperoxy 2-ethylhexyl carbonate, 0.5 g of vinyl trimethoxysilane and 0.5 g of PMMA microspheres with an average particle diameter of about 10 µm.

After uniformly mixing these components, the encapsulation adhesive film may be formed using the above described common process of preparing the encapsulation adhesive film.

### (Example 17 to Example 20)

The components of the disclosed encapsulation adhesive films in these Examples are substantially the same as the ones in Example 16, except type, particle diameter, and amount of the transparent spherical materials. Table 4 discloses detailed descriptions and results of Examples 17-20.

### (Comparative Example 4)

The components of encapsulation adhesive film in Comparative Example 4 are substantially the same as the ones in Example 16, except that the transparent microspheres are not mixed in the encapsulation adhesive film in Comparative Example 4. Table 4 discloses detailed results of Comparative Example 4.

### (Application Example 4)

Six solar cell modules were prepared using a solar cell module preparation method based on the same sets of a tempered glass, a solar cell layer, and a backplane. Encapsulation adhesive films prepared from Examples 16 through 20, and Comparative Example 4 were respectively used as an upper-layer adhesive film for bonding the tempered glass and the solar cell layer, and the encapsulation adhesive film prepared from Comparative Example 4 was also used as a lower-layer adhesive film for bonding the solar cell layer and the backplane in each of the six solar cell modules. The generated power output of each of the six solar cell modules was measured, and results are listed in Table 4.

**Table 4**

| | Example 16 | Example 17 | Example 18 | Example 19 | Example 20 | Comparative Example 4 |
|---|---|---|---|---|---|---|
| Transparent spherical materials | 0.5g of PMMA microspheres with 10µm diameter | 0.1g of PMMA microspheres with 10µm diameter | 1.5g of PMMA microspheres with 10µm diameter | 0.5g of PMMA microspheres with 1µm diameter | 0.5g of glass beads with 10µm diameter | - |
| Open-circuit voltage (V) | 5.638864 | 5.634298 | 5.553679 | 5.636889 | 5.566723 | 5.640179 |
| Short circuit current (A) | 8.303842 | 8.149177 | 8.194105 | 8.147936 | 8.191132 | 7.857137 |
| Maximum Power (W) | 34.68291 | 34.35025 | 34.47723 | 34.34512 | 34.45774 | 33.14981 |
| Power Factor | 0.740704 | 0.748129 | 0.757618 | 0.747787 | 0.755689 | 0.748038 |

As shown in Table 4, encapsulation adhesive films incorporating the disclosed transparent spherical material have increased the power output of the solar cell module in a certain amount.

### INDUSTRIAL APPLICABILITY AND ADVANTAGEOUS EFFECTS

The present disclosure may have various positive effects. (1) The present disclosure provides an encapsulation adhesive film that incorporates transparent spherical materials. The diffuse reflection characteristics of the transparent spherical material may be utilized to increase the number of times that the light reflects and refracts in the adhesive film, which may further improve luminous flux of the solar cell module, thereby increasing power output. (2) The present disclosure provides an encapsulation adhesive film for solar cell module that may incorporate different polymer materials, glass, or ceramic materials according to different conditions of use, thus has broad application prospects.

## Claims

1. An encapsulation adhesive film for a solar cell module, **characterized in that**,
the encapsulation adhesive film includes a transparent spherical material with an average particle diameter of 0.1 µm to 50 µm added during a process of preparing the encapsulation adhesive film.

2. The encapsulation adhesive film for the solar cell module according to claim 1, **characterized in that**,
the transparent spherical material includes at least one of transparent spherical polymer beads, transparent spherical glass beads, and transparent spherical ceramic beads.

3. The encapsulation adhesive film for the solar cell module according to claim 1, **characterized in that**,
a weight of the transparent spherical material is 0.01 % to 10% of a total weight of the encapsulation adhesive film.

4. The encapsulation adhesive film for the solar cell module according to claim 2, **characterized in that**,
a weight of the transparent spherical material is 0.01 % to 10% of a total weight of the encapsulation adhesive film.

5. The encapsulation adhesive film for the solar cell module according to any one of claims 1-4, **characterized in that**,
a bulk material of the encapsulation adhesive film is at least one of POE, EVA, PVB, TPU, epoxy resin, and organosilicon.

6. The encapsulation adhesive film for the solar cell module according to claim 5, **characterized in that**,
the bulk material of the encapsulation adhesive film is POE.

7. The encapsulation adhesive film for the solar cell module according to claim 5, **characterized in that**,
the bulk material of the encapsulation adhesive film is EVA.

8. The encapsulation adhesive film for the solar cell module according to claim 5, **characterized in that**,
the bulk material of the encapsulation adhesive film is PVB.

9. The encapsulation adhesive film for the solar cell module according to claim 5, **characterized in that**,
the bulk material of the encapsulation adhesive film is POE and EVA.
